# EUROPÄISCHE PATENTANMELDUNG

(11) **EP 0 889 584 A2**
(43) Veröffentlichungstag der Anmeldung: **07.01.1999**
(21) Anmeldenummer: 98112380.5
(22) Anmeldetag: 03.07.1998
(51) Int. Cl.: H03H 7/12

(54) **Schaltungsanordnung zum Umschalten und Abregeln von parallel zueinander verschalteten Frequenz bereichsfilterzweigen**

(30) Priorität: 03.07.1997 DE 19728463
(71) Anmelder: SIEMENS AKTIENGESELLSCHAFT, 80333 München (DE)
(72) Erfinder: Kuhn, Ralph, 85591 Vaterstetten (DE); Musiol, Lothar, 81735 München (DE)

(57) **Zusammenfassung**

Schaltungsanordnung zum Umschalten und Abregeln von parallel zueinander verschalteten Frequenzbereichsfilterzweigen (F1,F2,...,Fi), bei der mindestens zwei an einen Regelspannungsanschluß (E_{R}) gekoppelte Frequenzbereichsfiiterzweige zwischen einem Wechselspannungseingangsanschluß (IN_{RF}) und einem Wechselspannungsausgangsanschluß (OUT_{RF}) angeordnet sind. In jedem Frequenzbereichsfilterzweig sind zwei entgegengesetzt gerichtet geschaltete Dioden (D11,D21;D12,D22;...; D1i,D2i) vorgesehen, die sowohl zum Durchschalten als auch zum Abregeln des jeweils eingeschaltenten Frequenzbereichsfilterzweiges verwendet werden.

## Beschreibung

Die Erfindung bezieht sich auf eine Schaltungsanordnung zum Umschalten und Abregeln von parallel zueinander verschalteten Frequenzbereichsfilterzweigen, bei der mindestens zwei an einen Regelspannungsanschluß gekoppelte Frequenzbereichsfilterzweige zwischen einem Wechselspannungseingangsanschluß und einem Wechselspannungsausgangsanschluß angeordnet sind.

In Verstärker- und Umsetzerschaltungen für zwei oder mehr unterschiedliche Frequenzbänder muss zwischen mehreren für verschiedene Frequenzbänder vorgesehenen Freqenzbereichsfiltern umgeschaltet werden. Zur Vermeidung von Übersteuerungen der den Frequenzbereichsfilter nachgeordneten Schaltungsstufen befinden sich in den vor oder hinter den Frequenzbereichsfiltern liegenden Signalwegen häufig gleichspannungsgesteuerte Regelstufen zur Signalabschwächung.

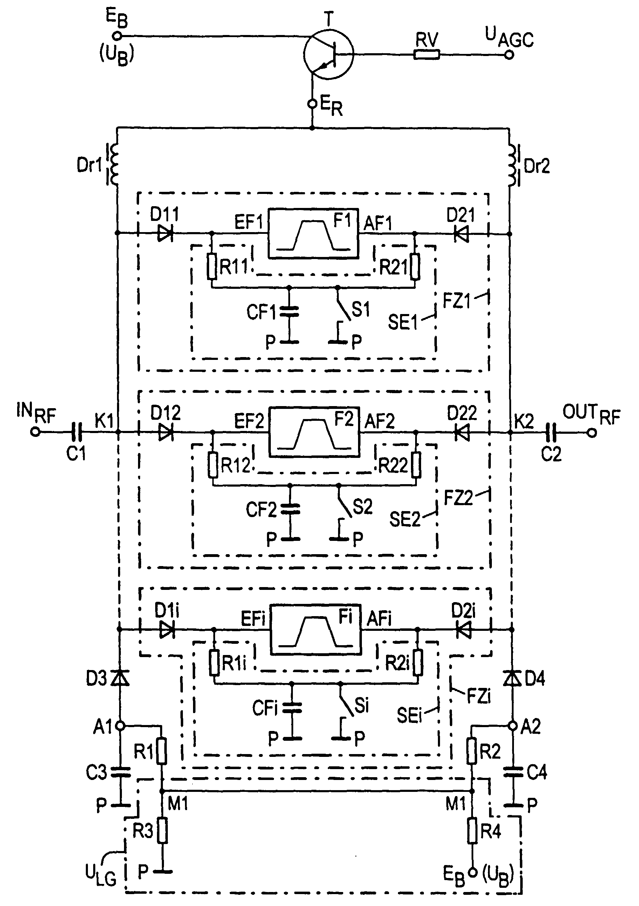

Derartige Schaltungsanordnungen zum Umschalten von Frequenzbereichsfiltern, z. B. Bandpässen, sind beispielsweise aus Elektor 5/97, S. 51, Abb. 7, bekannt. Spannungsgesteuerte Regelstufen mit PIN-Dioden als Dämpfungsglied in T- Schaltung sind beispielsweise aus Elektor 5/97, S. 49, Abb. 5, bekannt.

Die bekannten Schaltungsanordnungen der eingangs genannten Art erfordern einen hohen Bauteileaufwand, weisen einen vergleichsweise hohen Gesamtstromverbrauch auf und besitzen eine insgesamt hohe Grunddämpfung.

Der vorliegenden Erfindung liegt die Aufgabe zugrunde, eine demgegenüber verbesserte Schaltungsanordnung der eingangs genannten Art zur Verfügung zu stellen, die insbesondere einen reduzierten Bauteileaufwand und einen reduzierten Gesamtstromverbrauch aufweist.

Diese Aufgabe wird durch eine Schaltunganordnung mit den Merkmalen des Anspruches 1 gelöst. Vorteilhafte Weiterbildungen und Ausführungsformen der erfindungsgemäßen Schaltungsanordnung sind Gegenstand der Unteransprüche 2 bis 6.

Erfindnungsgemäß ist bei der Schaltungsanordnung der eingangs genannten Art in jedem Frequenzbereichsfilterzweig eine Reihenschaltung aus mindestens einem Frequenzbereichsfilter und mindestens einer ersten und einer zweiten Diode vorgesehen. Die erste Diode und die zweite Diode sind zueinander entgegengesetzt gerichtet geschaltet. In jedem Frequenzbereichsfilterzweig ist eine Schalteinheit vorgesehen. Mit dieser wird im Betrieb der Schaltungsanordnung zum Einschalten des zugehörigen Frequenzbereichsfilters die erste und die zweite Diode dieses Frequenzbereichsfilterzweiges auf Durchlaß geschaltet.

Zur Realisierung einer Abregelstufe für den jeweils eingeschalteten Frequenzbereichsfilter ist ein erster Anschluß einer dritten Diode mit einem ersten Knoten der parallel zueinander verschalteten Frequenzbereichsfilterzweige und ein erster Anschluß einer vierten Diode mit einem zweiten Knoten der parallel zueinander verschalteten Frequenzbereichsfilterzweige verbunden, derart, dass die dritte Diode und die vierte Diode zu den ersten bzw. den zweiten Dioden bzgl. ihrer Durchlaßrichtung gleich gerichtet geschaltet ist, und ist ein zweiter Anschluß der dritten und der vierten Diode an einen ersten bzw. einen zweiten Anschluß für eine lastabhängige Gleichspannungsquelle gekoppelt. Darüberhinaus sind der erste Knoten und der zweite Knoten an den Gleichspannungsanschluß gekoppelt, der den Regelspannungseingang darstellt. Mit diesem gesteuerten Potential wird die Betriebsdämpfung des aktiven Frequenzbereichsfilterzweiges eingestellt.

Die Abregelstufe ist somit im Wesentlichen jeweils von der ersten und der zweiten Diode des gerade eingeschalteten Frequenbereichsfilterzweiges in Verbindung mit der dritten und der vierten Diode in Form eines Π-Regelgliedes realisiert. Die erste und die zweite Diode des wahlweise eingeschalteten Frequenbereichsfilterzweiges wird folglich sowohl zum Durchschalten des Frequenzfilterzweiges als auch zum Abregeln des zugehörigen Frequenzfilters benutzt. Dadurch läßt sich vorteilhafterweise gegenüber den bekannten Schaltungsanordnungen eine Reduktion der Zahl der erforderlichen Bauteile erzielen.

Darüberhinaus weist die erfindungsgemäße Schaltungsanordnung einen vergleichsweise geringen Stromverbrauch und eine vergleichsweise geringe Grunddämpfung auf. Aufgrund der zweiten Längsdiode im Π-Regelglied ist weiterhin vorteilhafterweise auch der Abregelumfang sehr hoch.

Bei einer bevorzugten Ausführungsform der erfindungsgemäßen Schaltungsanordnung sind sowohl die ersten und die zweiten Dioden als auch die dritte und die vierte Diode PIN-Dioden.

Bei einer weiteren bevorzugten Ausführungsform der erfindungsgemäßen Schaltungsanordnung weisen die Schalteinheiten jeweils einen Ein-Aus-Schalter, bevorzugt einen elektronischen Schalter auf, der einerseits an einen Verbindungspunkt zwischen einem ersten elektrischen Widerstand und einem zweiten elektrischen Widerstand gekoppelt und andererseits mit einem festen Bezugspotential verbunden ist. Der erste und der zweite elektrische Widerstand sind mit ihren zweiten Anschlüssen an den Eingang bzw. an den Ausgang des zugehörigen Frequenzbereichsfilters gekoppelt. Der Wechselstromweg zum Eingang und Ausgang des jeweiligen Frequenzbereichsfilters ist mittels einer Kapazität, die einerseits an den Verbindungspunkt zwischen dem ersten und dem zweiten Widerstand und andererseits an das feste Bezugspotential gekoppelt ist, zum festen Bezugspotential, bevorzugt Masse, abgeblockt. Der elektronische Schalter ist beispielsweise bevorzugt ein Open-Kollektor-Schaltausgang eines integrierten Schaltkreises.

Bei einer besonders bevorzugten Weiterbildung der erfindungsgemäßen Schaltungsanordnung und der oben genannten Ausführungsformen ist als lastabhängige Gleichspannungs(U_{LG})-Quelle ein einerseits mit einem Gleichspannungsanschluß, bevorzugt mit dem Betriebsspannungs(U_{B})-Anschluß, und andererseits mit dem festen Bezugspotential verbundener Spannungsteiler vorgesehen, dessen Spannungsabgriff mit dem ersten und dem zweiten Anschluß verbunden ist.

Der Vorteil dieser Anordnung besteht insbesondere darin, dass bei geeigneter Auslegung der Wellenwiderstand des Systems bei Abregelung erhalten bleibt.

Die Schaltungsanordnung ist insbesondere für den Einsatz im TV-Frequenzbereich vorgesehen. Ein Einsatz in anderen Frequenzbereichen ist aber ebenso denkbar.

Weitere Vorteile und vorteilhafte Weiterbildungen der erfindungsgemäßen Schaltungsanordnung ergeben sich aus dem im Folgenden in Verbindung mit der Figur näher erläuterten Ausfürhungsbeispiel. Die Figur zeigt einen Schaltplan des Ausführungsbeispieles.

Bei der Schaltungsanordnung gemäß der Figur ist zwischen einem Wechselspannungseingangsanschluss IN_{RF} und einem Wechselspannungsausgangsanschluss OUT_{RF} eine Parallelschaltung, bestehend aus einer Mehrzahl von Frequenzbereichsfilterzweigen FZ1,FZ2,...,FZi angeordnet. Zwischen dem Wechselspannungseingangsanschluss IN_{RF} und einem ersten Knotenpunkt K1 der Parallelschaltung ist eine erste Kapazität C1 und zwischen einem zweiten Knotenpunkt K2 der Parallelschaltung und dem Wechselspannungsausgangsanschluss OUT_{RF} ist eine zweite Kapazität C2 angeschlossen. Diese beiden Kapazitäten C1 und C2 dienen im Wesentlichen zur Gleichspannungsentkopplung der Wechselspannungsanschlüsse IN_{RF} und OUT_{RF}.

An die Knotenpunkte K1 und K2 ist über die beiden Drosselelemente Dr1,Dr2 ein Regelspannungsanchluß E_{R} angekoppelt, über den im Betrieb den Knotenpunkten K1 und K2 ein Gleichstrom zugeführt wird. An Stelle der Drosselelemente Dr1 und Dr2 sind auch geeignete ohmsche Widerstände verwendbar.

Am Regelspannungsanschluß E_{R} ist in diesem Beispiel der Emitter eines ein pnp-Transistors T angeschlossen, dessen Kollektor mit dem Betriebsspannungseingang E_{B} und dessen Basis über einen elektrischen Widerstand RV mit einem Steinerspannungsanschluß U_{AGC} verbunden ist.

Jeder Frequenzbereichsfilterzweig FZ1,FZ1,...,FZi besteht aus einem Frequenzbereichsfilter F1,F2,...,Fi, der zwischen zwei Dioden D11,D21;D12,D22;...;D1i,D2i, bevorzugt PIN-Dioden, mit diesen in Reihe geschaltet ist. Die beiden PIN-Dioden sind bezüglich ihrer Durchlassrichtungen entgegengesetzt gerichtet geschaltet.

An jedem Frequenzbereichsfilter F1,F2,...,Fi ist zwischen den beiden zugehörigen Dioden D11,D21;D12,D22;...;D1i,D2i eine Gleichstromzuführung, bestehend aus einem ersten Widerstand R11,R12,...,R1i und einem zweiten Widerstand R21,R22,...,R2i angeschlossen. Der erste Widerstand R11,R12,...,R1i und der zweite Widerstand R21,R22,...,R2i sind jeweils einerseits an den Eingang EF1,EF2,...,EFi bzw. an den Ausgang AF1,AF2,...,AFi des zugehörigen Frequenzbereichsfilter F1,F2,...,Fi angeschlossen und andererseits miteinander verbunden. Die jeweilige Verbindungsleitung zwischen den beiden Widerständen R11,R21;R12,R22;...;R1i,R2i ist jeweils mittels einer an diese gekoppelte Kapazität CF1,CF2,...,CFi, die mit ihrem zweiten Anschluß auf dem festen Potential P, bevorzugt Masse, liegt, wechselstrommäßig abgeblockt. Weiterhin ist diese Verbindungsleitung mit einem ersten Schalteranschluß eines 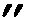 Ein-Aus"-Schalters S1,S2,...,Si, bevorzugt eines elektronischen Schalters wie beispielsweise ein Open-Kollektor-Schaltausgang eines integrierten Schaltkreises, verbunden, dessen zweiter Schalteranschluss auf einem festen Bezugspotential liegt.

Parallel zu den Frequenzbereichsfilterzweigen FZ1,FZ1,...,FZi ist eine Reihenschaltung aus einer dritten Diode D3, einem ersten Widerstand R1, einem zweiten Widerstand R2 und einer vierten Diode D4 angeschlossen, in der die beiden Dioden D3 und D4 bezüglich ihrer Durchlassrichtung entgegengesetzt gerichtet geschaltet und bevorzugt ebenfalls PIN-Dioden sind. Weiterhin sind die beiden Widerstände R1 und R2 einerseits mit den beiden Dioden D3 bzw. D4 und andererseits mit einem Mittelabgriff M1 eines Spannungsteilers, bestehend aus einem dritten Widerstand R3 und einem vierten Widerstand R4, verbunden.

Der Spannungsteiler ist einerseits mit dem Betriebsspannungsanschluss E_{B} und andererseits mit dem festen Bezugspotential P verbunden.

Zwischen der dritten Diode D3 und dem ersten Widerstand R1 sowie zwischen der vierten Diode D4 und dem zweiten Widerstand R2 ist eine dritte Kapazität C3 bzw. eine vierte Kapazität C4 angeschlossen, die mit ihren zweiten Anschlüssen mit dem festen Bezugspotential P verbunden ist. Diese Kapazitäten C3,C4 dienen zur Ableitung der Wechselspannung zum festen Bezugspotential P, z. B. zur Masse.

Die Umschaltung zwischen den einzelnen Frequenzbereichsfilterzweigen FZ1,FZ1,...,FZi wird mittels der Diodenpaare D11, D21;D12,D22;...;D1i,D2i vollzogen, die durch die Schalter S1,S2,...,Si wahlweise in Fluss gebracht werden.

Das jeweils aktive Diodenpaar D11,D21;D12,D22;...;D1i,D2i wird hier vorteilhafterweise gleichzeitig als Längsglied eines regelbaren Π-Dämpfungsgliedes genutzt, dessen Querglieder die dritte und die vierte Diode D3,D4 sind. Letztere sind im aufgeregelten Zustand stromlos (hochohmig). Bei Abregelung von U_{R} fließt durch sie Strom und sie werden niederohmiger, während der Strom durch das jeweilige aktive Diodenpaar D11,D21;D12,D22;...;D1i,D2i des in Betrieb befindlichen Frequenzbereichsfilterzweiges FZ1,FZ1,...,FZi mit der Regelspannung sinkt, wodurch diese hochohmiger werden.

Bei einer derart erfindungsgemäß gestalteten Schaltungsanordnung ist gegenüber Schaltungsanordnungen mit getrennten Stufen der Bauteileaufwand, der Gesamt-Stromverbrauch und die Grunddämpfung bei gleichzeitiger Verbesserung des Abregelumfanges (hervorgerufen durch die zweiten Längsdioden im Frequenzbereichsfilterzweig) reduziert.

## Patentansprüche

1. Schaltungsanordnung zum Umschalten und Abregeln von parallel zueinander verschalteten Frequenzbereichsfilterzweigen (FZ1,FZ2,...,FZi), bei der mindestens zwei Frequenzbereichsfilterzweige (FZ1,FZ2,...,FZi) zwischen einem Wechselspannungseingangsanschluß (IN_{RF}) und einem Wechselspannungsausgangsanschluß (OUT_{RF}) angeordnet sind,
**dadurch gekennzeichnet**,
dass in jedem Frequenzbereichsfilterzweig (FZ1,FZ2,...,FZi) mindestens ein Frequenzbereichsfilter (F1,F2,...,Fi) seriell zwischen mindestens einer ersten und mindestens einer zur ersten bzgl. ihrer Durchlassrichtung entgegengesetzt gerichtet geschalteten zweiten Diode (D11,D21;D12,D22;...;D1i,D2i) angeordnet ist,
dass in jedem Frequenzbereichsfilterzweig (FZ1,FZ2,...,FZi) eine Schalteinheit (SE1,SE2,...,SEi) vorgesehen ist, mit der im Betrieb der Schaltungsanordnung zum Einschalten des zugehörigen Frequenzbereichsfilters (F1,F2,...,Fi) die erste und die zweite Diode (D11,D21;D12,D22;...;D1i,D2i) dieses Frequenzbereichsfilterzweiges (FZ1,FZ2,...,FZi) auf Durchlaß geschaltet werden,
dass ein erster Anschluß einer dritten Diode (D3) mit einem ersten Knoten (K1) und ein erster Anschluß einer vierten Diode (D4) mit einem zweiten Knoten (K2) der parallel zueinander verschalteten Frequenzbereichsfilterzweige (FZ1,FZ2,...,FZi) verbunden ist, derart, dass die dritte und die vierte Diode (D3,D4) zu den ersten Dioden (D11,D12,...,D1i) bzw. den zweiten Dioden (D21,D22,...,D2i) bzgl. ihrer Druchlassrichtung gleich gerichtet geschaltet ist,
dass jeweils ein zweiter Anschluß der dritten und der vierten Diode (D3,D4) an einen ersten bzw. einen zweiten Anschluß (A1,A2) für eine lastabhängige Gleichspannungsquelle gekoppelt ist und
dass sowohl der erste Knoten (K1) als auch der zweite Knoten (K2) an einen Regelspannungsanschluß (E_{R}) gekoppelt sind.

2. Schaltungsanordnung nach Anspruch 1,
**dadurch gekennzeichnet**,
dass sowohl die ersten und die zweiten Dioden (D11,D21;D12,D22;...;D1i,D2i) als auch die dritte und die vierte Diode (D3,D4) PIN-Dioden sind.

3. Schaltungsanordnung nach Anspruch 1 oder 2,
**dadurch gekennzeichnet**,
dass die Schalteinheiten (SE1,SE2,...,SEi) jeweils aufweisen, einen ersten elekrischen Widerstand (R11,R12,...,R1i) und einem zweiten elektrischen Widerstand (R21,R22,...,R2i), die jeweils einerseits am Eingang bzw. am Ausgang des zugehörigen Frequenzbereichsfilters (F1,F2,...,Fi) angeschlossen sind und andererseits miteinander verbunden sind,
einen Ein-Aus-Schalter (S1,S2,...,Si), der einerseits zwischen dem ersten elekrischen Widerstand (R11,R12,...,R1i) und dem zweiten elektrischen Widerstand (R21,R22,...,R2i) angeschlossen ist und andererseits mit einem festen Bezugspotential (P) verbunden ist und
eine Kapazität (CF1,CF2,...,CFi), die ebenfalls einerseits zwischen dem ersten elekrischen Widerstand (R11,R12,...,R1i) und dem zweiten elektrischen Widerstand (R21,R22,...,R2i) angeschlossen ist und andererseits mit einem festen Bezugspotential (P) verbunden ist.

4. Schaltungsanordnung nach einem der Ansprüche 1 bis 3,
**dadurch gekennzeichnet**,
dass als lastabhängige Gleichspannungsquelle (U_{LG}) ein einerseits mit einem Gleichspannungsanschluß (E_{B}) und andererseits mit dem festen Bezugspotential (P) verbinndener Spannungsteiler (R3,R4) vorgesehen ist, dessen Spannungsabgriff (M1) mit dem ersten und dem zweiten Anschluß (A1,A2) verbunden ist.

5. Schaltungsanordnung nach Anspruch 4,
**dadurch gekennzeichnet**,
dass zwischen dem Spannungsabgriff (M1) und dem ersten Anschluß (A1) und zwischen dem Spannungsabgriff (M1) und dem zweiten Anschluß (A2) jeweils ein elektrischer Widerstand (R1,R2) vorgesehen ist.

6. Schaltungsanordnung nach einem der Ansprüche 1 bis 5,
**dadurch gekennzeichnet**,
dass zwischen dem ersten Knoten (K1) und dem Regelspannungsanschluß (E_{R}) und zwischen dem zweiten Knoten (K2) und dem Regelspannungsanschluß (E_{R}) jeweils ein Drosselelement (Dr1,Dr2) oder ein ohmscher Widerstand gekoppelt ist.
